(19) Europäisches Patentamt
European Patent Office
Office européen des brevets

(11) **EP 3 699 648 A1**

(12) **EUROPÄISCHE PATENTANMELDUNG**

(43) Veröffentlichungstag:
**26.08.2020 Patentblatt 2020/35**

(51) Int Cl.:
*G02B 1/115* (2015.01)    *B32B 43/00* (2006.01)
*C23C 14/00* (2006.01)    *G02B 5/08* (2006.01)
*G02B 5/28* (2006.01)    *C23C 14/24* (2006.01)

(21) Anmeldenummer: **19158947.2**

(22) Anmeldetag: **22.02.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Carl Zeiss Vision International GmbH 73430 Aalen (DE)**

(72) Erfinder: **VON BLANCKENHAGEN, Bernhard 73433 Aalen (DE)**

(74) Vertreter: **Louis Pöhlau Lohrentz Patentanwälte Postfach 30 55 90014 Nürnberg (DE)**

(54) **INTERFERENZSCHICHTSYSTEM OHNE TRÄGERSUBSTRAT, VERFAHREN ZUR HERSTELLUNG DESSELBEN UND DESSEN VERWENDUNG**

(57)    Die Erfindung betrifft ein Interferenzschichtsystem, umfassend eine Mehrzahl von optisch transparenten Schichten, wobei das Interferenzschichtsystem kein Trägersubstrat aufweist und wobei die optisch transparenten Schichten flächig übereinander angeordnet sind, wobei die optisch transparenten Schichten aus der Gruppe, die aus Dielektrika, Metallen und Kombinationen davon besteht, ausgewählt werden, wobei wenigstens eine erste optisch transparente Schicht einen Brechungsindex $n_1$ und wenigstens eine zweite optisch transparente Schicht einen Brechungsindex $n_2$ aufweist und wobei sich der erste Brechungsindex $n_1$ und der zweite Brechungsindex $n_2$ um wenigstens 0,1 unterscheiden. Die Erfindung betrifft ferner die Herstellung und die Verwendung des Interferenzschichtsystems.

EP 3 699 648 A1

**Beschreibung**

Die vorliegende Erfindung betrifft ein Interferenzschichtsystem, das eine Mehrzahl von optisch transparenten Schichten umfasst. Die vorliegende Erfindung betrifft des Weiteren ein Verfahren zur Herstellung eines solchen Interferenzschichtsystems als auch dessen Verwendung.

Optische Interferenzschichtsysteme sind seit langem bekannt und werden für unterschiedlichste Zwecke eingesetzt. Gemeinsam ist allen optischen Interferenzschichtsystemen, dass Schichten zum Einsatz kommen, deren Dicke in der Größenordnung der Wellenlänge des Lichts liegt. Je nachdem, ob ein optisches Interferenzschichtsystem für kurze Wellenlängen, beispielsweise den UV-Spektralbereich, oder für längere Wellenlängen, beispielsweise den infraroten (IR) Spektralbereich, ausgelegt ist, ergeben sich unterschiedliche Schichtdicken. Optische Interferenzschichtsysteme bestehen aus Stapeln von Schichten mit unterschiedlichem Brechungsindizes. Je nach Aufgabenstellung ergeben sich Schichtstapel mit unterschiedlicher Anzahl einzelner Schichten, unterschiedlicher Anzahl verschiedener Schichtmaterialien sowie unterschiedlicher Schichtdicken.

Auf Basis der physikalischen Gesetzmäßigkeiten von optischen Interferenzschichten lassen sich die optischen Eigenschaften von Oberflächen für das Licht definiert verändern, so dass spezielle technische Anforderungen realisiert werden können. Ein Beispiel ist die Verringerung der Reflektivität einer Oberfläche, wobei eine solche Anwendung eines Interferenzschichtsystems auch als Entspiegelungsschicht oder Antireflexionsschicht bezeichnet wird.

Beispielsweise beträgt im sichtbaren Spektralbereich, d.h. von etwa 380 nm bis etwa 780 nm, die Reflexion eines Glases mit einem Brechungsindex von n=1,5 etwa 4%.

Durch Aufbringen eines Interferenzschichtsystems, welches als Entspiegelungsschicht ausgelegt ist, kann die Reflexion auf Werte unter 1% im sichtbaren Spektralbereich verringert werden. Vielfache Anwendung finden solche Entspiegelungsschichten bei optischen Systemen, bei denen jede Linsenoberfläche eine solche Entspiegelungsschicht erhält. Auch auf Brillengläsern finden Entspiegelungsschichten Verwendung, wie dies aus der EP 2 437 084 A1 bekannt ist.

Neben der Entspiegelung finden geeignet ausgelegte Interferenzschichtsysteme auch breite Verwendung für Anwendungen zur Erhöhung der Reflexion, z.B. bei Spiegel-Schichtsystemen, bei der Wellenlängenfilterung, z.B. bei Farbfiltern, bei der Teilung eines Lichtstroms in 2 polarisierte Anteile, z.B. bei Polarisationsstrahlteilern, bei der Teilung von Wellenlängenbereichen, z.B. bei Langpass- oder Kurzpassfiltern, sowie bei der Erzeugung definierter Phasenverschiebungen. Allen diesen Anwendungen ist gemeinsam, dass das Interferenzschichtsystem auf ein Substrat aufgebracht ist. Neben der reinen Trägerfunktion des Substrates für das Interferenzschichtsystem tragen viele Substrate auch zur optischen Abbildung eines optischen Systems bei, indem diese beispielsweise als Linsen, abbildende Spiegel, Strahlteilerplatten oder Strahlteilerwürfel wirken. Diese Substrate sind im Hinblick auf die Wirkungsweise nicht Bestandteil des optischen Interferenzschichtsystems, da diese Substrate typischerweise dicker als die Kohärenzlänge des eingesetzten Lichts sind. Die Kohärenzlänge von Licht ist, allgemein ausgedrückt, die Länge, über die elektromagnetische Wellen zur Interferenz in der Lage sind. Ist eine Schicht oder ein Substrat dicker als diese Länge, trägt diese Schicht oder das Substrat nicht zur optischen Interferenz bei.

Es besteht ein Bedarf an optischen Filtern, die selektiv definierte Wellenlängenbereiche aus eingestrahltem Licht, beispielsweise Sonnenlicht, herausfiltern oder reflektieren können. Auch besteht ein Bedarf an optischen Filtern, die im Hinblick auf den zu filternden oder zu reflektierenden Spektralbereich selektiv einstellbar sind, beispielsweise neben einer Reflektorwirkung für den UV-A-Anteil des Sonnenlichtes auch eine Filterwirkung bis in den blauen Spektralbereich des sichtbaren Lichtes oder beispielsweise eine selektive Filterwirkung für den IR-Anteil des Sonnenlichts aufweisen. Des Weiteren besteht ein Bedarf an Filtern, deren Abmessungen auf einfache Art und Weise verringert werden können. Insbesondere ist es wünschenswert, dass ein solcher Filter nach einer Zerkleinerung beispielsweise in einem Anwendungsmedium verwendbar und für Mensch und Umwelt unbedenklich ist.

Für eine Anwendung in einem Anwendungsmedium wie in einem Lack oder in einer Druckfarbe sind aus der EP 0 950 693 A1 Interferenzschichtsysteme in Form von Perlglanzpigmenten bekannt, die ein innenliegendes zentral angeordnetes Trägersubstrat aufweisen und bei einem Betrachter einen Farbeindruck hervorrufen.

Bei den aus der EP 0 950 693 A1 bekannten Perlglanzpigmenten werden auf ein Substratplättchen, beispielsweise $SiO_2$-Plättchen, etc., hoch- und niedrigbrechende Schichten nasschemisch umhüllend aufgebracht. Die Perlglanzpigmente erzeugen in der Regel einen für den Betrachter winkelabhängigen Farbeindruck. Mithin ergibt sich bei Perlglanzpigmenten üblicherweise ein zum Substratplättchen symmetrischer Schichtaufbau auf der Oberseite und der Unterseite des Substratplättchens, wobei die hoch- und niedrigbrechenden Schichten in den Randbereichen aufgrund der Umhüllung geschlossen vorliegen. Die äußerste Schicht umhüllt die nächstinnenliegende Schicht, die wiederum die sodann nächstinnenliegende Schicht, etc. umhüllt. Bei der in EP 0 950 693 A1 beschriebenen Anwendung besteht jedoch der Nachteil, dass die Möglichkeiten zur Einstellung des spektralen Verhaltens eingeschränkt sind, beispielsweise da bei der Herstellung dieser Pigmente nur eine eng begrenzte Anzahl von Schichten abgeschieden werden kann.

Die der vorliegenden Erfindung zugrundeliegende Aufgabe wird durch Bereitstellung eines Interferenzschichtsystems, umfassend eine Mehrzahl von optisch transparenten Schichten, gelöst, wobei das Interferenzschichtsystem kein Trägersubstrat aufweist und wobei die optisch transparenten Schichten flächig übereinander angeordnet sind, wobei die optisch transparenten Schichten aus der Gruppe, die aus Dielektrika, Metallen und Kombinationen davon besteht, ausgewählt werden, wobei wenigstens eine erste optisch transparente Schicht einen Brechungsindex $n_1$ und wenigstens eine zweite optisch transparente Schicht einen Brechungsindex $n_2$ aufweist und wobei sich der erste Brechungsindex $n_1$ und der zweite Brechungsindex $n_2$ um wenigstens 0,1 unterscheiden.

Unter "optisch transparenter Schicht" oder "optisch transparenten Schichten" wird im Sinne der Erfindung verstanden, dass die Schicht bzw. die Schichten im Wesentlichen kein Licht im sichtbaren Spektralbereich, vorzugsweise kein Licht im sichtbaren Spektralbereich, und/oder im Wesentlichen keine Strahlung im IR-Bereich, vorzugsweise keine Strahlung im IR Bereich, absorbiert bzw. absorbieren. Unter "im Wesentlichen keine Absorption" wird eine geringe Absorption verstanden. Vorzugsweise ist/sind die optisch transparente(n) Schicht(en) für Licht im sichtbaren Spektralbereich oder für Strahlung im IR-Bereich transparent. Vorzugsweise ist/sind die "optisch transparente(n) Schicht(en) im Wesentlichen nur für Licht im sichtbaren Spektralbereich transparent. Vorzugsweise ist/sind die "optisch transparente(n) Schicht(en) im Wesentlichen nur für Strahlung im IR-Bereich transparent. Unter "optisch transparenter Schicht" oder "optisch transparenten Schichten" wird im Sinne der Erfindung gemäß einer Ausführungsform der Erfindung weiter vorzugsweise verstanden, dass die Materialien, aus denen die Schicht aufgebaut ist bzw. die Schichten aufgebaut sind, im sichtbaren Spektralbereich vorzugsweise nur eine geringe, weiter vorzugsweise keine, Absorption aufweisen.

Der sichtbare Spektralbereich erfasst einen Wellenlängenbereich von 380 nm bis 780 nm.

Der IR-Bereich (IR: Infrarotstrahlung) erfasst im Sinne der Erfindung nahes IR in einem Wellenlängenbereich von 800 nm bis 1100 nm.

Der UV-A-Bereich (UV: ultraviolette Strahlung) erfasst im Sinne der Erfindung einen Wellenlängenbereich von 315 nm bis 400 nm.

Unter "transparent" wird für eine einzelne Schicht im Sinne der Erfindung verstanden, dass wenigstens 20 % des auf eine optisch transparente Schicht einfallenden sichtbaren Lichts bzw. der einfallenden IR-Strahlung durch die Schicht hindurchtritt. Vorzugsweise liegt die Transparenz einer Schicht in einem Bereich von 25 % bis 100%, weiter vorzugsweise von 30 % bis 98 %, weiter vorzugsweise von 40 % bis 95 %, weiter vorzugsweise von 45 % bis 90 %, weiter vorzugsweise von 50 % bis 85 %, weiter vorzugsweise von 55 % bis 80 %, weiter vorzugsweise von 60 % bis 75 %.

Bei der Anordnung mehrerer optisch transparenter Schichten übereinander in einem Schichtpaket wird die Transmission durch die Interferenzeffekte bestimmt. Über den Spektralverlauf kann es mithin Wellenlängenbereiche mit hoher Transmission und Wellenlängenbereiche mit niedriger Transmission geben. Vorzugsweise weist ein Schichtpaket, das aus den mehreren optisch transparenten Schichten besteht, eine Transmission von mehr als 20 %, vorzugsweise in einem gewünschten Wellenlängenbereich, auf. Vorzugsweise liegt die Transmission des gesamten Schichtpakets, in einem Bereich von 25 % bis 100 %, weiter vorzugsweise von 30 % bis 98 %, weiter vorzugsweise von 40 % bis 95 %, weiter vorzugsweise von 45 % bis 90 %, weiter vorzugsweise von 50 % bis 85 %, weiter vorzugsweise von 55 % bis 80 %, weiter vorzugsweise von 60 % bis 75 %.

Die optischen Eigenschaften der Materialien, aus denen die Schichten aufgebaut sind, werden im Hinblick auf die optischen Eigenschaften vorzugsweise durch den Brechungsindex n und weiter vorzugsweise durch den Absorptionsindex *k* definiert. Optisch transparente Schichtmaterialien weisen im Spektralbereich, welcher durch die jeweilige Anwendung bestimmt wird, vorzugsweise einen Absorptionsindex *k* < 0,008, weiter bevorzugt von *k* < 0,005, weiter bevorzugt von *k* < 0,003, weiter bevorzugt von *k* < 0,001, auf. Der Absorptionsindex wird auch als Extinktionskoeffizient oder als Imaginärteil des komplexen Brechungsindexes bezeichnet.

Im Sinne der Erfindung beziehen sich die Angaben der Brechungsindizes $n_1$ und $n_2$ und des Absorptionsindexes *k* durchweg auf den jeweiligen bei einer Wellenlänge von 550 nm gemessenen Brechungsindex bzw. Absorptionsindex.

Der klassische Brechungsindex, auch Brechzahl oder optische Dichte genannt, ist eine optische Materialeigenschaft. Der klassische Brechungsindex ist das Verhältnis der Wellenlänge des Lichts im Vakuum zur Wellenlänge im Material. Der Brechungsindex ist dimensionslos und im Allgemeinen von der Frequenz des Lichts abhängig.

Der komplexe Brechungsindex setzt sich aus einem Realteil $n_r$, d.h. dem klassischen Brechungsindex, und einem Imaginärteil *k* gemäß Formel (I) zusammen:

$$n = n_r\text{-}i k \qquad\qquad\qquad (I)$$

Der komplexe Brechungsindex beschreibt sowohl das zeitliche und räumliche Fortschreiten der Welle als auch deren Absorption. Der reellwertige Anteil $n_r$, der meist größer als 1 ist, verkürzt die Wellenlänge im Medium. Der komplexwertige Anteil dämpft die Welle.

Unter einem Interferenzschichtsystem wird im Sinne der Erfindung eine Anordnung von mehreren optisch transparenten Schichten verstanden, bei der es bei eingestrahltem Licht aufgrund von Reflexions- und Transmissionsphänomenen an den einzelnen optisch transparenten Schichten zu konstruktiver und destruktiver Interferenz kommt.

Gemäß einer bevorzugten Ausführungsform besteht das erfindungsgemäße Interferenzschichtsystem ausschließlich aus dieser Anordnung von mehreren optisch transparenten Schichten, bei der es bei eingestrahltem Licht aufgrund von Reflexions- und Transmissionsphänomenen an den einzelnen optisch transparenten Schichten zu konstruktiver und destruktiver Interferenz kommt. Bei dem Interferenzschichtsystem handelt es sich erfindungsgemäß um einen Stapel optisch transparenter Schichten, wie in Anspruch 1 spezifiziert, zur Erzeugung von optischer Interferenz. Infolge dieser Reflexions- und Transmissionsphänomene an den verschiedenen Schichten des Interferenzschichtsystems kommt es zu einer Verringerung der Intensität des transmittierten Lichts in bestimmten Wellenlängenbereichen, vorzugsweise zu einer Auslöschung von Wellenlängenbereichen, wodurch eine optische Filterwirkung erzeugt wird. Das Interferenzschichtsystem im Sinne der Erfindung kann auch als Interferenzfilter bezeichnet werden.

Das Interferenzschichtsystem der vorliegenden Erfindung weist kein Trägersubstrat auf. Mithin enthält das erfindungsgemäße Interferenzschichtsystem keine plättchenförmigen Substrate, wie beispielsweise Glasplättchen, $SiO_2$-Plättchen, $Al_2O_3$-Plättchen, natürlichen oder synthetischen Glimmerplättchen, etc. Auch ist das erfindungsgemäße Interferenzschichtsystem nicht auf einem Brillenglas, einem optischen Linsensubstrat, einer Glasscheibe, einer Kunststofffolie oder einer Kunststoffplatte, etc. angeordnet.

Gemäß einer Ausführungsform der Erfindung kann das Interferenzschichtsystem auch als UV-A-Reflektor (UV: ultraviolettes Licht) wirken, wobei das UV-A-Licht reflektiert wird.

Gemäß einer weiteren Ausführungsform der Erfindung kann das Interferenzschichtsystem eine Filterwirkung für einen Wellenlängenbereich von 360 nm bis 450 nm aufweisen.

Gemäß einer weiteren Ausführungsform der Erfindung kann das Interferenzschichtsystem eine Filterwirkung für bestimmte Wellenlängenbereiche des sichtbaren Lichts haben, wie nachstehend in Tabelle 1 spezifiziert.

**Tabelle 1**:

| Farbe | Wellenlängenbereich [nm] |
|---|---|
| Violett | 380-450 |
| Blau | 450-482 |
| Grünlich-Blau | 482-487 |
| Cyan (Blau) | 487-492 |
| Bläulich-Grün | 492-497 |
| Grün | 497-530 |
| Gelblich-Grün | 530-560 |
| Gelb-Grün | 560-570 |
| Grünlich-Gelb | 570-575 |
| Gelb | 575-580 |
| Gelblich-Orange | 580-585 |
| Orange | 585-595 |
| Rötlich-Orange | 595-620 |
| Rot | 620-780 |

Gemäß einer weiteren Ausführungsform der Erfindung kann das Interferenzschichtsystem als Wärmereflexionsfilter ausgebildet sein, vorzugsweise im nahen Infrarotbereich. Das nahe Infrarot (IR) wird dabei in IR-A in einem Bereich von 780 nm bis 1,4 $\mu$m und in IR-B in einem Bereich von 1,4 $\mu$m bis 3 $\mu$m unterteilt. Vorzugsweise weist das erfindungsgemäße Interferenzschichtsystem eine Filterwirkung im IR-A Bereich auf.

Gemäß einer weiteren bevorzugten Ausführungsform ist das erfindungsgemäße Interferenzschichtsystem ein Wärmereflexionsfilter für einen Wellenlängenbereich von 800 bis 850 nm.

Gemäß einer weiteren bevorzugten Ausführungsform ist das erfindungsgemäße Interferenzschichtsystem ein Wärmereflexionsfilter für einen Wellenlängenbereich von 850 bis 900 nm.

Gemäß einer weiteren bevorzugten Ausführungsform ist das erfindungsgemäße Interferenzschichtsystem ein Wärmereflexionsfilter für einen Wellenlängenbereich von 870 bis 950 nm.

Gemäß einer weiteren bevorzugten Ausführungsform ist das erfindungsgemäße Interferenzschichtsystem ein Wärmereflexionsfilter für einen Wellenlängenbereich von 1000 bis 1100 nm.

Die Filtereigenschaften des erfindungsgemäßen Interferenzschichtsystems können durch eine Auswahl der Materialien, aus denen die einzelnen Schichten des Interferenzschichtsystems bestehen, deren Schichtdicke und/oder der Anzahl der Schichten eingestellt werden. Das erfindungsgemäße Interferenzschichtsystem kann beispielsweise definierte Werte für die Reflexion, die Transmission und/oder die Absorption für das auf das Interferenzschichtsystem auftreffende Licht aufweisen. Die Filtereigenschaften des erfindungsgemäßen Interferenzschichtsystem können auch unter bestimmten Einfallswinkeln des auftreffenden Lichts vorliegen. Ist der Einfallswinkel von 0° verschieden, können die Filtereigenschaften auch die polarisierten Anteile des auftreffenden Lichts betreffen. Unter einem Winkel von 0° wird der Fall verstanden, dass der Lichtstrahl lotrecht auf die Fläche trifft. Weicht der Einfallswinkel von 0° wird der Einfallswinkel zum Lot auf diese Fläche gemessen.

Das erfindungsgemäße Interferenzschichtsystem, das kein Trägersubstrat aufweist, kann vorteilhafterweise im Hinblick auf definierte Filtereigenschaften, die vorzugsweise aus der Gruppe, die aus Reflexion, Transmission, Absorption, spektrale Lichtfilterung, und Kombinationen davon, besteht, ausgewählt werden, bereitgestellt werden.

Das Interferenzschichtsystem gemäß der vorliegenden Erfindung wird vorzugsweise durch Aufdampfen, vorzugsweise mittels physikalischer Dampfabscheidung (PVD: physical vapour deposition), hergestellt. Es ist auch möglich, die einzelnen Schichten durch chemische Dampfabscheidung (CVD: chemical vapour deposition) oder durch Sputtern zu erzeugen. Gemäß einer bevorzugten Ausführungsform der Erfindung erfolgt das Aufbringen der einzelnen Schichten mittels PVD.

Mithin kann das Interferenzschichtsystem der vorliegenden Erfindung auch als durch Dampfabscheidung erzeugtes Interferenzschichtsystem, beispielsweise als PVD-Interferenzschichtsystem oder CVD-Interferenzschichtsystem, bezeichnet werden. Das erfindungsgemäße Interferenzschichtsystem ist vorzugsweise nicht nasschemisch, beispielsweise durch Auffällen der einzelnen Schichten auf- und nacheinander in einer Flüssigphase, hergestellt. Gemäß einer bevorzugten Ausführungsform der Erfindung ist das erfindungsgemäße Interferenzschichtsystem ein PVD-Interferenzschichtsystem.

Das Interferenzschichtsystem oder der Interferenzfilter der vorliegenden Erfindung kann dabei filmartig oder folienartig ausgebildet sein. In diesem Fall kann das Interferenzschichtsystem auch als Interferenzschichtfilm oder als Interferenzschichtfolie bezeichnet werden.

Das Interferenzschichtsystem kann auch partikulär ausgebildet sein. Das partikuläre Interferenzschichtsystem weist über die gesamte Fläche eine konstante Dicke mit einer maximalen Abweichung von $\pm$ 10 %, vorzugsweise $\pm$ 5 %, weiter vorzugsweise $\pm$ 2 %, jeweils bezogen auf die Gesamtschichtdicke des Stapels der übereinander aufgebrachten einzelnen Schichten. Die erfindungsgemäßen Interferenzschichtpartikel weisen eine ebene Oberfläche auf. Da das partikuläre Interferenzschichtsystem durch Zerkleinerung aus dem Interferenzschichtfilm oder der Interferenzschichtfolie erzeugt wird, weist es vorzugsweise zum mindestens teilweise gerade Bruchkanten auf.

Bei einer weiteren Ausführungsform kann das Interferenzschichtsystem der vorliegenden Erfindung auch als UV-A-Reflektor bzw. UV-A-Interferenzfilter bezeichnet werden. Mithin kann der Interferenzschichtfilm auch als UV-A-Interferenzfilterfilm bzw. kann die Interferenzschichtfolie auch als UV-A-Interferenzfilterfolie bezeichnet werden. Die Interferenzschichtpartikel können auch als UV-A-Interferenzfilterpartikel oder UV-A-Reflektorpartikel bezeichnet werden.

Gemäß einer bevorzugten Weiterbildung der Erfindung kann das erfindungsgemäße Interferenzschichtsystem neben einer Reflektorwirkung im UV-A-Bereich zusätzlich auch eine Filterwirkung im Violett- und/oder Blaulichtbereich des sichtbaren Lichts aufweisen. Gemäß einer weiteren bevorzugten Ausführungsform der Erfindung verringert das erfindungsgemäße Interferenzschichtsystem die Transmission im Bereich von 360 nm bis 450 nm.

Bei einer weiteren Ausführungsform kann das Interferenzschichtsystem der vorliegenden Erfindung auch als Kurzpass-Interferenzfilter bezeichnet werden. Mithin kann der Interferenzschichtfilm auch als Kurzpass-Interferenzfilterfilm bzw. kann die Interferenzschichtfolie auch als Kurzpass-Interferenzfilterfolie bezeichnet werden. Die Interferenzschichtpartikel können auch als Kurzpass-Interferenzfilterpartikel bezeichnet werden. Ein Kurzpassfilter weist vorzugsweise einen hohen Transmissionsgrad für kurze Wellenlängen und einen geringen Transmissionsgrad für lange Wellenlängen auf. Kurze Wellenlängen liegen dabei vorzugsweise in einem Bereich von 380 nm bis 780 nm, weiter vorzugsweise von 420 nm bis 800 nm. Ein Beispiel für einen Kurzpassfilter ist ein IR-Filter, der eine geringe Transmission im IR-Bereich, jedoch eine hohe Transmission im sichtbaren Bereich aufweist.

Bei einer weiteren Ausführungsform kann das Interferenzschichtsystem der vorliegenden Erfindung auch als Langpass-Interferenzfilter bezeichnet werden.

Mithin kann der Interferenzschichtfilm auch als Langpass-Interferenzfilterfilm bzw. kann die Interferenzschichtfolie auch als Langpass-Interferenzfilterfolie bezeichnet werden. Die Interferenzschichtpartikel können auch als Langpass-Interferenzfilterpartikel bezeichnet werden. Ein Langpassfilter weist vorzugsweise einen hohen Transmissionsgrad für lange Wellenlängen und einen geringen Transmissionsgrad für kurze Wellenlängen auf. Lange Wellenlängen liegen dabei vorzugsweise in einem Bereich von 420 nm bis 780 nm, weiter vorzugsweise von 450 nm bis 800 nm. Ein Beispiel für einen Langpassfilter ist ein UV-Reflektor/Violett-Filter, der sichtbares Licht transmittiert.

Bei einer weiteren Ausführungsform kann das Interferenzschichtsystem der vorliegenden Erfindung auch als Bandpass-Interferenzfilter bezeichnet werden. Mithin kann der Interferenzschichtfilm auch als Bandpass-Interferenzfilterfilm bzw. kann die Interferenzschichtfolie auch als Bandpass-Interferenzfilterfolie bezeichnet werden. Die Interferenzschichtpartikel können auch als Bandpass-Interferenzfilterpartikel bezeichnet werden. Ein Bandpassfilter weist vorzugsweise einen hohen Transmissionsgrad für ein bestimmtes Wellenlängenband auf, während kürzere und längere Wellenlängen reflektiert oder absorbiert werden. Ein solches transmittierte Wellenlängenband kann beispielsweise in einem Bereich von 500 nm bis 600 nm, weiter beispielsweise in einem Bereich von 540 nm bis 580 nm, liegen. Der transmittierte Wellenlängenbereich kann aber auch ein anderes Wellenlängenband betreffen.

Bei einer weiteren Ausführungsform kann das Interferenzschichtsystem der vorliegenden Erfindung auch als Bandsperr-Interferenzfilter bezeichnet werden. Mithin kann der Interferenzschichtfilm auch als Bandsperr-Interferenzfilterfilm bzw. kann die Interferenzschichtfolie auch als Bandsperr-Interferenzfilterfolie bezeichnet werden. Die Interferenzschichtpartikel können auch als Bandsperr-Interferenzfilterpartikel bezeichnet werden. Ein Bandsperrfilter weist vorzugsweise einen geringen Transmissionsgrad für einen bestimmten Wellenlängenbereich auf, während kürzere und längere Wellenlängen durchgelassen werden. Ein solcher Wellenlängenbereich mit geringer Transmission kann beispielsweise in einem Bereich von 500 nm bis 600 nm, weiter beispielsweise von 540 nm bis 580 nm, liegen. Der Wellenlängenbereich mit geringer Transmission kann aber auch einen anderen Wellenlängenbereich betreffen.

Bei einer weiteren Ausführungsform kann das Interferenzschichtsystem der vorliegenden Erfindung auch als IR-Interferenzfilter bezeichnet werden. Mithin kann der Interferenzschichtfilm auch als IR-Interferenzfilterfilm bzw. kann die Interferenzschichtfolie auch als IR-Interferenzfilterfolie bezeichnet werden. Die Interferenzschichtpartikel können auch als IR-Interferenzfilterpartikel bezeichnet werden. Ein IR-Interferenzfilter weist vorzugsweise einen geringen Transmissionsgrad für IR-Strahlung im Bereich von 800 nm bis 1100 nm, vorzugsweise von 850 nm bis 1000 nm, auf.

Bei Verwendung des erfindungsgemäßen Interferenzschichtsystems in einem Anwendungsmedium, beispielsweise einem Beschichtungsmittel, kommt es vorzugsweise zu keiner wesentlichen für einen Betrachter wahrnehmbaren Farbänderung oder Farberzeugung, vorzugsweise zu keiner Farbänderung oder Farberzeugung bei dem Anwendungsmedium, beispielsweise Beschichtungsmittel, sofern das Interferenzschichtsystem für den UV-A-Spektralbereich als Reflektor ausgelegt ist. Der vorzugsweise weitgehend farblose oder neutrale, weiter vorzugsweise farblose oder neutrale, Eindruck ermöglicht die Verwendung des erfindungsgemäßen Interferenzschichtsystems als optischen Filter und/oder beispielsweise als Reflektor für UV-A-Licht in einem Anwendungsmedium, beispielsweise Beschichtungsmittel, ohne dabei das Anwendungsmedium, beispielsweise Beschichtungsmittel, farblich wesentlich zu verändern. Nach einem Auftragen des Beschichtungsmittels wird der Untergrund durch das erfindungsgemäße Interferenzschichtsystem optisch ebenfalls nicht wesentlich verändert, vorzugsweise nicht verändert.

Ebenfalls kommt es bei Verwendung des erfindungsgemäßen Interferenzsystems in einem Anwendungsmedium, beispielsweise einem Beschichtungsmittel, zu keiner Farbänderung oder Farberzeugung bei dem Anwendungsmedium, beispielsweise Beschichtungsmittel, sofern das Interferenzschichtsystem für den IR-Spektralbereich als Filter oder Reflektor ausgelegt ist.

Sofern das erfindungsgemäße Interenzschichtsystem als Farbmittel verwendet werden soll, kann es einem Anwendungsmedium, beispielsweise einem Beschichtungsmittel, beispielsweise einem Lack, einer Farbe oder Druckfarbe, auch eine Färbung, beispielsweise blau, grün, gelb, rot, oder Kombinationen davon, verleihen.

Die der Erfindung zugrundeliegende Aufgabe wird mithin durch Bereitstellung eines Interferenzschichtsystems gemäß Anspruch 1 gelöst, das vorzugsweise weiterhin eine Reflekor- und/oder Filterwirkung im UV-A-Licht Bereich und vorzugsweise auch zusätzlich im Wellenlängenbereich von 380 nm bis 430 nm aufweist, wodurch die Transmission des UV-A-Lichtes durch das Interferenzschichtsystem und vorzugsweise zusätzlich auch im Wellenlängenbereich von 380 nm bis 430 nm, vorzugsweise um mehr 25 %, weiter bevorzugt um mehr als 50 %, noch weiter bevorzugt um mehr als 60%, verringert wird, jeweils bezogen auf die Transmission ohne die Filterwirkung.

Um die Filterwirkung zu optimieren, können die Schichtdicken der Mehrzahl von optisch transparenten Schichten in dem Interferenzschichtsystem und/oder die Anzahl der Schichten in Abhängigkeit des jeweiligen Brechungsindex und im Hinblick auf den zu reflektierenden und/oder herauszufilternden Wellenlängenbereich aufeinander eingestellt werden.

Erfindungswesentlich ist, dass das Interferenzschichtsystem kein Trägersubstrat aufweist. Unter einem Trägersubstrat wird im Sinne der Erfindung ein Substrat verstanden, auf das die optisch transparenten Schichten aufgebracht sind, wobei das Substrat üblicherweise mechanisch stabiler als die optisch transparenten Schichten ist.

Gemäß einer bevorzugten Weiterbildung der Erfindung ist das erfindungsgemäße Interferenzschichtsystem ausschließlich aus Dielektrikaschichten, vorzugsweise ausschließlich aus Metalloxidschichten, aufgebaut. Bei dieser Ausführungsform enthält das erfindungsgemäße Interferenzschichtsystem vorzugsweise keine rein metallischen Schichten und/oder Schichten, die elementares Metall enthalten.

Gemäß einer weiteren bevorzugten Ausführungsform der Erfindung kann das Interferenzsystem wenigstens eine optisch semitransparente Metallschicht aufweisen. Das Interferenzsystem der Erfindung kann dabei ausschließlich aus mehreren semitransparenten Metallschichten aufgebaut sein. Bei den Metallen kann es sich um Silber, Gold, Aluminium, Chrom, Titan, Eisen, oder Legierungen, oder Mischungen davon handeln. Eine Metallschicht ist im Allgemeinen semitransparent, wenn die Schichtdicke weniger als 40 nm beträgt. Vorzugsweise weist eine Metallschicht bei dem erfindungsgemäßen Interferenzschichtsystem eine Dicke in einem Bereich von 5 nm bis 38 nm, weiter vorzugsweise von 8 nm bis 35 nm, noch weiter vorzugsweise von 10 nm bis 30 nm, noch weiter vorzugsweise von 15 nm bis 25 nm auf.

Gemäß einer weiteren Ausführungsform der Erfindung weist das Interferenzschichtsystem sowohl Schichten, die aus Dielektrika, vorzugsweise Metalloxid(en), bestehen, als auch Schichten, die aus Metall(en) bestehen, auf. Beispielsweise kann ein erfindungsgemäßes Interferenzschichtsystem im Wesentlichen aus Dielektrikaschichten, vorzugsweise Schichten aus Metalloxid(en), bestehen und zusätzlich beispielsweise eine, zwei oder drei Schichten aus Metall(en), aufweisen.

Gemäß einer weiteren Ausführungsform der Erfindung kann das Interferenzschichtsystem auch semitransparente Schichten aufweisen, die einen Absorptionsindex $k > 0,001$, vorzugsweise $k > 0,003$, vorzugsweise $k > 0,005$, weiter vorzugsweise $k > 0,008$, beispielsweise $k > 0,01$, haben. Hierbei kann es sich beispielsweise um Metalloxide bei Wellenlängen, die kürzer als die Wellenlänge der Absorptionskante sind, handeln.

Das Interferenzschichtsystem der vorliegenden Erfindung ist unter anderem dadurch gekennzeichnet, dass ein Trägersubstrat für die optisch transparenten Schichten nicht vorhanden ist. Die Erfinder haben festgestellt, dass, wenn die optisch transparenten Schichten als solche flächig übereinander und vorzugsweise unmittelbar flächig aneinander angrenzend angeordnet sind, ein mechanisch überraschend stabiles Interferenzschichtsystem erhalten wird, das insbesondere handhabbar ist.

Das Interferenzschichtsystem der vorliegenden Erfindung kann dabei als Film oder Folie oder auch partikulär ausgebildet sein. Vorzugsweise besteht das erfindungsgemäße Interferenzschichtsystem ausschließlich aus den flächig übereinander angeordneten optisch transparenten Schichten, wobei diese jeweils im Wesentlichen, vorzugsweise vollständig, aus einem dielektrischen Material oder mehreren dielektrischen Materialien, vorzugsweise einem Metalloxid oder mehreren Metalloxiden, bestehen.

So kann das Interferenzschichtsystem filmartig oder folienartig mit einer Größe von mehreren Quadratzentimetern ausgebildet sein. Das Interferenzschichtsystem kann beispielsweise eine Fläche von 1 cm$^2$ bis 400 cm$^2$, vorzugsweise von 2 cm$^2$ bis 250 cm$^2$, weiter vorzugsweise von 4 cm$^2$ bis 150 cm$^2$, aufweisen.

Gemäß einer weiteren bevorzugten Ausführungsform der Erfindung kann das erfindungsgemäße Interferenzschichtsystem auch mit einer oder mehreren weiteren Oberflächenschicht(en), d.h. außen auf dem Schichtstapel aus optisch transparenten Schichten angeordneten Oberflächenschichten, versehen sein, die keine optischen Funktionen hat/haben, sondern die Anwendungseigenschaften verbessern. Beispielsweise kann das erfindungsgemäße Interferenzschichtsystem eine Hydrophobierungsschicht aufweisen, um beispielsweise einer etwaigen Verschmutzung entgegenzuwirken. Auch können beispielsweise Interferenzschichtpartikel oberflächlich chemisch modifiziert sein, um einer Aggregation oder einer Sedimentation, beispielweise in einem Anwendungsmedium wie einem Beschichtungsmittel, entgegenzuwirken.

Das Interferenzschichtsystem kann dabei eine Flexibilität aufweisen, so dass der Film oder die Folie aufrollbar ist.

Ungeachtet der Flexibilität des Interferenzschichtsystems ist eine Zerkleinerung desselben unter Einwirkung mechanischer Kräfte ohne weiteres möglich. So kann das in Film- oder Folienform bereitgestellte Interferenzschichtsystem unter Einwirkung mechanischer Kräfte unter Bereitstellung von Interferenzschichtpartikeln oder Interferenzfilterpartikel zerkleinert werden. Diese Partikel können eine Fläche von 1 $\mu m^2$ bis 1 cm$^2$, vorzugsweise 5 $\mu m^2$ bis 40.000 $\mu m^2$, weiter vorzugsweise von 10 $\mu m^2$ bis 10.000 $\mu m^2$, weiter vorzugsweise von 100 $\mu m^2$ bis 5.000 $\mu m^2$, aufweisen.

Bevorzugte Ausführungsformen des erfindungsgemäßen Interferenzschichtsystems sind in den abhängigen Ansprüchen 2 bis 10 angegeben.

Die der Erfindung zugrundeliegende Aufgabe wird des Weiteren durch Bereitstellung eines Verfahrens zur Herstellung eines Interferenzschichtsystems gemäß einem der Ansprüche 1 bis 10 gelöst, wobei das Verfahren die folgenden Schritte umfasst:

(a) Bereitstellen eines flächigen Trägersubstratmaterials,
(b) Aufbringen einer Trennschicht,
(c) Aufbringen einer Mehrzahl optisch transparenter Schichten unter Erzeugung eines Interferenzschichtsystems,
(d) Ablösen des Interferenzschichtsystems von dem flächigen Trägersubstratmaterial.

Bevorzugte Weiterbildungen des erfindungsgemäßen Verfahrens sind in den abhängigen Ansprüchen 12 und 13 angegeben.

Gemäß einer bevorzugten Ausführungsform des erfindungsgemäßen Verfahrens weist das flächige Trägersubstrat eine geringe Oberflächenrauigkeit, vorzugsweise eine Oberflächenrauigkeit von < 3 nm rms, weiter vorzugsweise von < 2 nm rms, weiter vorzugsweise von < 1 nm rms, auf.

Unter "rms" wird die quadratische Rauigkeit (rms englisch: root-mean-squared roughness) verstanden, die auch als $R_q$ bezeichnet wird. Die quadratische Rauigkeit "rms" oder "$R_q$" stellt die Standardabweichung der Verteilung der Oberflächenhöhen dar, wie in E.S. Gadelmawla et al., "Roughness parameters", Journal of Materials Processing Technology 123 (2002) 133-145, Ziffer 2.2 erläutert, dessen Offenbarung hiermit unter Bezugnahme aufgenommen ist. Mathematisch ist die quadratische Rauigkeit $R_q$, wie in Formel (II) spezifiziert, definiert:

$$R_q = \sqrt{\frac{1}{l} \int_0^l \{y(x)\}^2 \, dx} \qquad \text{(II)},$$

wobei: "*l*" für die Messlänge,
"*y*" für die Oberflächenhöhe steht, und
wobei die Länge "*x*" von 0 bis "*l*" geht.

Des Weiteren wird die der Erfindung zugrundeliegende Aufgabe auch durch Bereitstellung eines optischen Filters, der ein Interferenzschichtsystems nach einem der Ansprüche 1 bis 10 ist oder enthält, gelöst. Der optische Filter kann dabei ein UV-Reflektor, Farbfilter, Wärmereflexionsfilter bzw. IR-Filter und/oder Antireflexionsfilter sein.

Schließlich wird die der Erfindung zugrundeliegende Aufgabe auch durch Bereitstellung eines Anwendungsmediums, das ein Interferenzschichtsystem nach einem der Ansprüche 1 bis 10, enthält, gelöst.

Gemäß einer bevorzugten Weiterbildung der Erfindung wird das Anwendungsmedium aus der Gruppe, die aus Glasuren, Gläsern, Kunststoffen, und Beschichtungsmitteln, vorzugsweise Farben, Lacken, Druckfarben, besteht, ausgewählt.

Gemäß einer weiter bevorzugten Ausführungsform der Erfindung ist das Anwendungsmedium ein Beschichtungsmittel.

Das erfindungsgemäße Interferenzschichtsystem zeichnet sich unter anderem dadurch aus, dass es kein Trägersubstrat aufweist.

Bei dem Interferenzschichtsystem der vorliegenden Erfindung sind die optisch transparenten Schichten flächig übereinander und vorzugsweise aneinander angrenzend angeordnet. Unter "aneinander angrenzend angeordnet" wird im Sinne der Erfindung verstanden, dass benachbarte Schichten unmittelbar, d.h. in flächigem Kontakt zueinander angeordnet sind. Die optisch transparenten Schichten sind dabei vorzugsweise in den Randbereichen bündig gestapelt. Mithin liegen bei dem erfindungsgemäßen Interferenzschichtsystem in den Randbereichen, d.h. "von der Seite" betrachtet, vorzugsweise "offene Schichtenden", d.h. nicht umhüllte Schichtenden vor.

Erfindungsgemäß sind die optisch transparenten Schichten nicht umhüllend aufgebracht. Vielmehr ist es bevorzugt, dass die optisch transparenten Schichten definierte Schichtstapel aus Schichten mit jeweils definierter Schichtdicke über die gesamte Breite des Interferenzschichtsystems sind. Bei dieser Anordnung der optisch transparenten Schichten liegt auch in den Randbereichen die identische und definierte Schichtenfolge mit jeweils definierter Schichtdicke wie im Mittelbereich des Interferenzschichtsystems vor. Die Kantenbereiche der optischen transparenten Schichten in dem Schichtstapel sind dabei vorzugsweise nicht umhüllt.

Gemäß einer bevorzugten Ausführungsform liegt die Schichtdicke jeder optisch transparenten Schicht in einem Dickenbereich von 5 nm zu 500 nm, vorzugsweise 6 nm bis 460 nm, vorzugsweise 7 nm bis 420 nm, vorzugsweise 8 nm bis 380 nm, vorzugsweise 9 nm bis 320 nm, vorzugsweise 10 nm bis 280 nm, vorzugsweise 11 nm bis 220 nm, vorzugsweise 12 nm bis 180 nm, vorzugsweise 13 nm bis 150 nm, vorzugsweise von 14 nm bis 120 nm, weiter vorzugsweise von 15 nm bis 110 nm, weiter vorzugsweise von 25 nm bis 90 nm, noch weiter bevorzugt von 30 nm bis 80 nm. Die Dicke jeder Schicht stellt dabei die räumliche Erstreckung der Schicht senkrecht zur Fläche dar.

Das Interferenzschichtsystem gemäß der vorliegenden Erfindung kann im Hinblick auf die Schichtenfolge einen symmetrischen oder einen asymmetrischen Schichtenaufbau aufweisen.

Ein asymmetrischer Schichtenaufbau kann sich beispielsweise dadurch ergeben, dass die Schichtdicke der in dem Schichtstapel angeordneten Schichten je nach Anordnung in dem Schichtenstapel voneinander verschieden ist. Auch kann sich ein asymmetrischer Schichtenaufbau dadurch ergeben, dass die in den einzelnen Schichten verwendeten Metalloxide voneinander verschieden sind, so dass sich kein symmetrischer Aufbau ergibt.

Auch kann sich ein asymmetrischer Schichtenaufbau dadurch ergeben, dass die beiden außenliegenden Schichten an der Oberseite bzw. Unterseite des Interferenzschichtsystems voneinander verschieden sind. Beispielsweise kann bei einer alternierenden Anordnung von hochbrechenden Schichten, beispielsweise $TiO_2$-Schichten, und niedrigbrechenden Schichten, beispielsweise $SiO_2$, die untere Fläche des Interferenzschichtsystems als $SiO_2$-Schicht und die obere Fläche des Interferenzschichtsystems als $TiO_2$-Schicht ausgebildet sein.

Bei dem erfindungsgemäßen Interferenzschichtsystem weist keine der optisch transparenten Schichten die Funktion eines Trägersubstrats auf. Überraschenderweise ergibt sich die mechanische Stabilität des erfindungsgemäßen Interferenzschichtsystems durch die Mehrzahl von optisch transparenten Schichten, die jeweils für sich betrachtet, üblicherweise keine ausreichende mechanische Stabilität aufweisen. Die Erfinder haben überraschenderweise herausgefunden, dass eine ausreichende mechanische Stabilisierung des Interferenzschichtsystems bereits dann vorliegt, wenn wenigstens 4, vorzugsweise wenigstens 6, weiter vorzugsweise wenigstens 8, weiter vorzugsweise wenigstens 10, weiter vorzugsweise wenigstens 12, weiter vorzugsweise wenigstens 14, optisch transparente Schichten übereinander angeordnet sind.

Das erfindungsgemäße Interferenzschichtsystem ist ein Flächengebilde, das vorzugsweise eine Gesamtdicke aus einem Bereich von 40 nm bis 5 $\mu$m, vorzugsweise von 80 nm bis 4 $\mu$m, weiter vorzugsweise von 140 nm bis 3 $\mu$m, noch weiter bevorzugt von 260 nm bis 2,5 $\mu$m, noch weiter bevorzugt von 400 nm bis 2 $\mu$m, noch weiter bevorzugt von 600 nm bis 1,5 $\mu$m aufweist. Als sehr geeignet hat sich ein Dickenbereich von 750 nm bis 1,3 $\mu$m, weiter bevorzugt von 800 nm bis 1,2 $\mu$m.

Gemäß einer weiteren bevorzugten Ausführungsform der Erfindung umfasst das Interferenzschichtsystem 4 bis 100, vorzugsweise 6 bis 80, weiter vorzugsweise 8 bis 70, noch weiter vorzugsweise 10 bis 60, noch weiter vorzugsweise 12 bis 50, noch weiter vorzugsweise 14 bis 40, optisch transparente Schichten oder besteht daraus.

Aufgrund der guten mechanischen Stabilität kann das erfindungsgemäße Interferenzschichtsystem als Film oder Folie, vorzugsweise als optischer Film oder optische Folie, ohne Trägersubstrat vorliegen. Das in Film- oder Folienform vorliegende erfindungsgemäße Interferenzschichtsystem ist dabei vorzugsweise flexibel, so dass das Interferenzschichtsystem gemäß einer Ausführungsform der Erfindung aufrollbar ist.

Das erfindungsgemäße Interferenzschichtsystem kann mithin als frei vorliegender Interferenzschichtfilm bzw. als frei vorliegende Interferenzschichtfolie oder als frei vorliegende Partikel vorliegen. Unter "frei" wird erfindungsgemäß verstanden, dass das erfindungsgemäße Interferenzschichtsystem in ungebundener Form, d.h. ohne Trägersubstrat bzw. von einem Trägersubstrat abgelöst, vorliegt.

Der erfindungsgemäße Interferenzschichtfilm bzw. die erfindungsgemäße Interferenzschichtfolie kann dabei eine Fläche von mehreren Quadratzentimetern, beispielsweise von 2 bis 400 cm$^2$, vorzugsweise von 3 bis 200 cm$^2$, weiter bevorzugt von 4 bis 120 cm$^2$, noch weiter bevorzugt von 8 bis 100 cm$^2$, aufweisen.

Das erfindungsgemäße Schichtsystem ist, vorzugsweise als Interferenzschichtfilm oder Interferenzschichtfolie, überraschenderweise gut handhabbar. So kann beispielsweise das als Interferenzschichtfilm oder Interferenzschichtfolie vorliegende Interferenzschichtsystem direkt als optischer Film, beispielsweise bei physikalischen Untersuchungen oder in komplexen optischen Systemen, beispielsweise in Halterungen angeordnet, verwendet werden.

Andererseits kann das in Filmform oder Folienform vorliegende Interferenzschichtsystem unter Einwirkung von mechanischen Kräften ohne weiteres zerkleinert werden. So kann beispielsweise der erfindungsgemäße Interferenzschichtfilm oder die erfindungsgemäße Interferenzschichtfolie durch Verwirbelung in einem Medium, beispielweise Gas oder einer Flüssigkeit, zerkleinert werden. Auch durch Einwirkung von beispielsweise Ultraschall kann das erfindungsgemäße Interferenzschichtsystem zerkleinert werden. In Abhängigkeit von der Zeitdauer und dem Energieeintrag während der Zerkleinerung kann eine definierte Größenverteilung eingestellt werden. So kann das erfindungsgemäße Interferenzschichtsystem auch einen mittleren Partikeldurchmesser, auch als mittlere Partikelgröße bezeichnet, von beispielsweise 1 $\mu$m bis 500 $\mu$m, weiter vorzugsweise 2 $\mu$m bis 400 $\mu$m, weiter vorzugsweise von 5 $\mu$m bis 250 $\mu$m, noch weiter vorzugsweise von 10 $\mu$m bis 170 $\mu$m, noch weiter vorzugsweise von 20 $\mu$m bis 130 $\mu$m, noch weiter vorzugsweise von 40 $\mu$m bis 90 $\mu$m vorliegen.

Unter einer mittleren Partikelgröße wird erfindungsgemäß der Medianwert D50 der volumengemittelten Größe verstanden, bei dem 50 % der Partikel eine Größe unterhalb des angegebenen D50-Wertes aufweisen und 50 % der Partikel eine Größe von oberhalb des angegebenen D50-Wertes aufweisen.

Die Partikelgrößenverteilung kann dabei mittels Laserdiffraktometrie, beispielsweise mittels CILAS 1064, bestimmt werden.

Die bei Zerkleinerung des Interferenzschichtsystems erhaltenen Partikel weisen über die gesamte Fläche des Partikels einen einheitlichen, mithin definierten Schichtaufbau, auch in den Randbereichen auf. Es hat sich überraschend gezeigt, dass nach Zerkleinerung des erfindungsgemäßen Interferenzschichtsystems die so erhaltenen Interferenzschichtpartikel mechanisch stabil sind und im Wesentlichen flächig vorliegen. Vorzugsweise liegen die Interferenzschichtpartikel mithin im Wesentlichen nicht in aufgerollter Form vor. Äußerst bevorzugt liegen die erfindungsgemäßen Interferenzschichtpartikel in flächiger Form, d.h. nicht in aufgerollter Form vor.

Gemäß einer weiteren bevorzugten Ausführungsform weisen die optisch transparenten Schichten jeweils ein oder mehrere Dielektrika, vorzugsweise Metalloxid(e), in einer Menge von 95 bis 100 Gew.-%, weiter bevorzugt 97 bis 99,5 Gew.-%, weiter bevorzugt 98 bis 99 Gew.-%, jeweils bezogen auf das Gesamtgewicht der jeweiligen optisch transparenten Schicht, auf.

Äußerst bevorzugt besteht jede optisch transparente Schicht ausschließlich aus einem Dielektrikum, vorzugsweise Metalloxid, oder aus mehreren Dielektrika, vorzugsweise Metalloxide. Gemäß einer weiteren bevorzugten Ausführungsform besteht jede optisch transparente Schicht aus einem einzigen Metalloxid.

Unter "Metalloxid(en)" werden im Sinne der Erfindung auch Metalloxidhydroxid(e) und Metallhydroxid(e) und auch Mischungen davon verstanden. Äußerst bevorzugt handelt es sich bei dem/ Metalloxid bzw. den Metalloxiden um reine(s) Metalloxid(e) ohne Wasseranteil.

Gemäß einer weiteren bevorzugten Ausführungsform weist das erfindungsgemäße Interferenzschichtsystem wenigstens zwei niedrigbrechende optisch transparente Schichten mit einem Brechungsindex $n_1 < 1,8$ und wenigstens zwei hochbrechende transparente Schichten mit einem Brechungsindex $n_2 \geq 1,8$ auf.

Gemäß einer weiteren bevorzugten Ausführungsform weist die niedrigbrechende optisch transparente Schicht einen Brechungsindex $n_1$ aus einem Bereich von 1,3 bis 1,78 auf und wird vorzugsweise aus der Gruppe, die aus Siliziumoxid, Aluminiumoxid, Magnesiumfluorid, und Mischungen davon besteht, ausgewählt. Als niedrigbrechendes Metalloxid kann auch Boroxid verwendet werden. Gemäß einer bevorzugten Ausführungsform der Erfindung sind die vorgenannten niedrigbrechenden Metalloxide röntgenamorph.

Vorzugsweise handelt es sich bei Siliziumoxid um $SiO_2$. Im Sinne der Erfindung wird Silziumoxid, insbesondere $SiO_2$, auch als Metalloxid verstanden. Bei Aluminiumoxid handelt es sich vorzugsweise um $Al_2O_3$ oder AlOOH. Bei Boroxid handelt es sich bevorzugt um $B_2O_3$. Bei Magnesiumfluorid handelt es sich vorzugsweise um $MgF_2$.

Äußerst bevorzugt wird die niedrigbrechende optische transparente Schicht aus der Gruppe, die aus Siliziumoxid, Aluminiumoxid, Magnesiumfluorid, und Mischungen davon besteht ausgewählt. Vorzugsweise sind die vorgenannten niedrigbrechenden Metalloxide röntgenamorph. Weiterhin bevorzugt liegt das Siliziumoxid als $SiO_2$ vor. Weiterhin bevorzugt liegt das Aluminiumoxid als $Al_2O_3$ vor Weiterhin bevorzugt liegt das Magnesiumfluorid als $MgF_2$ vor Gemäß einer weiteren bevorzugten Ausführungsform weist die hochbrechende optisch transparente Schicht einen Brechungsindex $n_2$ aus einem Bereich von 2,0 bis 2,9 auf und wird vorzugsweise aus der Gruppe, die aus Titanoxid, Eisenoxid, Nioboxid, Tantaloxid, Zirkoniumoxid, Zinnoxid, Ceroxid, Chromoxid, Kobaltoxid, und Mischungen davon besteht, ausgewählt. Gemäß einer bevorzugten Ausführungsform der Erfindung sind die vorgenannten hochbrechenden Metalloxide röntgenamorph.

Bei Titanoxid handelt es sich vorzugsweise um $TiO_2$. Weiter vorzugsweise liegt das $TiO_2$ als Anatas oder Rutil, noch weiter bevorzugt als Rutil, vor. Gemäß einer weiteren Ausführungsform der Erfindung liegt das $TiO_2$ amorph vor, d.h. vorzugsweise röntgenamorph. Das Eisenoxid liegt vorzugsweise als $Fe_2O_3$ (Hämatit) oder als $Fe_3O_4$ (Magnetit), weiter vorzugsweise als $Fe_2O_3$, vor. Das Nioboxid liegt vorzugsweise als $Nb_2O_5$ vor. Das Tantaloxid liegt vorzugsweise als $Ta_2O_5$ vor. Das Zirkoniumoxid liegt vorzugsweise als $ZrO_2$ vor. Das Zinnoxid liegt vorzugsweise als $SnO2$ vor.

Äußerst bevorzugt wird die hochbrechende Schicht aus der Gruppe, die aus Rutil, Nioboxid, Tantaloxid, Zirkoniumoxid, und Mischungen davon besteht, ausgewählt. Vorzugsweise sind die vorgenannten hochbrechenden Metalloxide röntgenamorph Gemäß einer weitere bevorzugten Ausführungsform liegt das Titanoxid als $TiO_2$, vorzugsweise als Rutil, vor.

Gemäß einer bevorzugten Ausführungsform der Erfindung weist das Interferenzschichtsystem eine alternierende Schichtfolge von zwei optischen transparenten Schichten auf, wobei die erste optisch transparente Schicht einen Brechungsindex $n_1$ und die zweite optisch transparenten Schicht einen Brechungsindex $n_2$ aufweist und wobei sich $n_1$ und $n_2$ vorzugsweise um 0,1 bis 1,4, weiter vorzugsweise um 0,2 bis 1,3, weiter vorzugsweise um 0,3 bis 1,2, weiter vorzugsweise um 0,4 bis 1,1, weiter vorzugsweise um 0,5 bis 1,0, weiter vorzugsweise um 0,6 bis 0,9, unterscheiden.

Gemäß einer bevorzugten Ausführungsform der Erfindung umfasst das Interferenzschichtsystem als niedrigbrechende Schicht Schichten aus Siliziumoxid, vorzugsweise $SiO_2$, und als hochbrechende Schicht Schichten aus Titanoxid, vorzugsweise $TiO_2$, weiter vorzugsweise amorphes $TiO_2$, wobei die Siliziumoxidschichten und die Titanoxidschichten vorzugsweise alternierend angeordnet sind. Vorzugsweise umfasst das erfindungsgemäße Interferenzschichtsystem in der Summe 4 bis 100, vorzugsweise 6 bis 80, vorzugsweise 8 bis 70, weiter vorzugsweise 10 bis 60, weiter vorzugsweise 12 bis 50, Titanoxidschichten und Siliziumoxidschichten oder besteht daraus. Gemäß einer bevorzugten Ausführungsform sind die Titanoxidschichten und Siliziumoxidschichten röntgenamorph.

Äußerst vorzugsweise besteht das Interferenzschichtsystem gemäß der vorliegenden Erfindung im Wesentlichen aus Metalloxid(en), vorzugsweise aus Metalloxid(en). Aufgrund der bevorzugten metalloxidischen Struktur ist das Interferenzschichtsystem gemäß der vorliegenden Erfindung nicht korrosionsanfällig. Die Aufbringung von separaten Korrosionsschutzschichten ist somit vorteilhafterweise nicht erforderlich. Das erfindungsgemäße Interferenzschichtsystem ist mithin auch in einer korrodierenden Umgebung, beispielsweise in Gegenwart von Wasser und Sauerstoff, gegenüber Korrosion stabil.

Äußerst vorteilhaft ist das Interferenzschichtsystem gemäß der vorliegenden Erfindung im Hinblick auch auf die in der Natur vorkommenden Metalloxide in gesundheitstechnischer und umwelttechnischer Hinsicht unbedenklich.

Die Erfindung betrifft auch die Verwendung eines Interferenzschichtsystem nach einem der Ansprüche 1 bis 10 als optischer Filter. Der optische Filter kann dabei als Film oder als Folie vorliegen. Beispielsweise kann der Interferenzschichtfilm oder die Interferenzschichtfolie in einer Halterung angeordnet sein.

Gemäß einer weiteren bevorzugten Ausführungsform betrifft die vorliegende Erfindung ein Anwendungsmedium, vorzugsweise ein Beschichtungsmittel, das ein optisches Interferenzschichtsystem nach einem der Ansprüche 1 bis 10 enthält.

Bei dem Beschichtungsmittel kann es sich um Lack, Farbe oder Medizinprodukte handeln.

Bei dem Anwendungsmedium kann es sich auch um eine Glasur, eine Keramik oder einen Kunststoff handeln.

Das Interferenzschichtsystem der vorliegenden Erfindung kann mit dem Verfahren gemäß Anspruch 11 hergestellt werden.

Erfindungsgemäß wird ein flächiges Trägersubstratmaterial bereitgestellt, das mit einer Trennschicht versehen wird. Auf diese Trennschicht werden sodann nacheinander eine Mehrzahl von optisch transparenten Schichten, die aus der Gruppe, die aus Dielektrika, Metallen, und Kombinationen davon besteht, ausgewählt werden, unter Erzeugung eines Interferenzschichtsystems gemäß einem der Ansprüche 1 bis 10 aufgebracht. Das so erhaltene Interferenzsystem wird nachfolgend von dem flächigen Trägersubstratmaterial abgelöst.

Bei dem flächigen Trägersubstratmaterial kann es sich um eine anorganische oder organische Oberfläche handeln. Als anorganische Oberfläche kann beispielsweise ein metallisches Substrat oder ein Keramiksubstrat verwendet werden. Als organische Oberfläche kann eine Kunststoffoberfläche verwendet werden. Die Kunststoffoberfläche kann dabei modifiziert sein, beispielsweise mit einem Lack, wie zum Beispiel einem Polysiloxan-basierten Hartlack.

Das Trägersubstratmaterial kann dabei immobil, beispielsweise als Plattensubstrat, oder mobil, beispielsweise als Bandsubstrat, ausgebildet sein.

Gemäß einer bevorzugten Ausführungsform der Erfindung wird als Trägersubstratmaterial ein Kunststoffmaterial verwendet, wie es auch zur Herstellung von Brillenkunststoffgläsern verwendet wird.

Das Trägersubstratmaterial kann ein Kunststoffmaterial umfassen oder daraus bestehen, wobei das Kunststoffmaterial aus der Gruppe, die aus Polythiourethan, Polyepisulfid, Polymethylmethacrylat, Polycarbonat, Polyallyldiglycolcarbonat, Polyacrylat, Polyurethan, Polyharnstoff, Polyamid, Polysulfon, Polyallyl, Fumarsäurepolymer, Polystyrol, Polymethylacrylat, Biopolymeren, und Mischungen davon besteht, ausgewählt werden. Vorzugsweise umfasst das Kunststoffmaterial ein Polymermaterial oder besteht daraus, dass aus der Gruppe, die aus Polythiourethan, Polyepisulfid, Polymethylmethacrylat, Polycarbonat, Polyallyldiglycolcarbonat, Polyacrylat, Polyurethan, Polyharnstoff, Polyamid, Polysulfon, Polyallyl, Fumarsäurepolymer, Polystyrol, Polymethylacrylat, Biopolymeren, und Mischungen davon besteht, ausgewählt wird.

Äußerst bevorzugt wird das Kunststoffmaterial aus der Gruppe, die aus Polyurethan, Polyharnstoff, Polythiourethan, Polyepisulfid, Polycarbonat, Polyallyldiglycolcarbonat, und Mischungen davon besteht, ausgewählt.

Als Kunststoffmaterial können die gleichen Materialien verwendet werden, wie sie auch bei der Herstellung von Kunststoffbrillengläsern verwendet werden. Geeignete Polymermaterialien sind beispielsweise unter den Handelsnamen MR6, MR7, MR8, MR10, MR20, MR174, CR39, CR330, CR607, CR630, RAV700, RAV7NG, RAV7AT, RAV710, RAV713, RAV720, TRIVEX, PANLITE, MGC 1.76, RAVolution, etc. erhältlich.

Das Basismaterial von CR39, CR330, CR607, CR630, RAV700, RAV7NG, RAV7AT, RAV710, RAV713 und RAV720 ist Polyallyldiglycolcarbonat. Das Basismaterial von RAVolution und TRIVEX ist Polyharnstoff/Polyurethan. Das Basismaterial von MR6, MR7, MR8 und MR10 ist Polythiourethan. Das Basismaterial von MR174 und MGC1.76 ist Polyepisulfid.

Diese aus der Kunststoffbrillenglasherstellung bekannten Kunststoffmaterialen werden üblicherweise mit Antireflexions- und Entspiegelungsschichten versehen, wobei diese jedoch dauerhaft auf der Kunststoffoberfläche aufgebracht sind.

Gemäß einer bevorzugten Ausführungsform der Erfindung wird das Trägersubstrat mit einem Lack, wie zum Beispiel einem Polysiloxan-basiertem Hartlack beschichtet ist. Dieser Lack bewirkt einen Schutz vor mechanischen Beschädigungen, beispielsweise von Kratzern. Gemäß einer weiteren bevorzugten Ausführungsform der Erfindung wird zwischen dem Trägersubstrat, beispielsweise Kunststoffsubstrat, und der Hartlackschicht eine Primerschicht angeordnet, die die Haftung der Hartlackschicht auf dem Trägersubstrat, beispielsweise Kunststoffsubstrat, verbessert.

Diese Lacke werden auch als Hartlacke bezeichnet. Diese werden typischerweise mit Tauchbeschichtungsverfahren oder Schleuderbeschichtungsverfahren flüssig auf beide Seiten des Substrates aufgebracht und dann beispielsweise thermisch ausgehärtet. In Abhängigkeit von der Zusammensetzung des Lacks kann die Härtung auch mit UV-Licht erfolgen. Das UV-Licht induziert dabei chemische Reaktionen, die zur Aushärtung des flüssigen Lacks führen.

Diese Hartlacke sind vorzugsweise härter als das Kunststoffsubstrat. Vorzugsweise weisen diese Lacke eine Indentationshärte größer als 150 MPa, bevorzugt größer als 250 MPa, gemessen mit Hilfe der Nanoindentierung, die auch als instrumentierte Eindringprüfung bezeichnet wird. Die instrumentierte Eindringtiefe wird dabei bestimmt, wie in Oliver W.C. und Pharr, G.M., "Measurement of hardness and elastic modulus by instrumented indentation: Advances in understanding and refinements to methodology", J. Mater. Res., Bd. 19, Nr. 1, Jan 2004, Seiten 3 bis 20, angegeben.

Die Schichtdicke der ausgehärteten Lackschicht beträgt typischerweise 1 $\mu$m, bevorzugt mehr als 1,5 $\mu$m, beispielsweise 2 $\mu$m oder 3 $\mu$m.

Bei einer weiteren Ausführungsform der Erfindung ist zunächst vorzugsweise direkt auf das Kunststoffsubstrat eine flüssige Primerschicht mittels Tauchbeschichtungsverfahren oder Schleuderbeschichtungsverfahren aufgebracht. Nach thermischer Trocknung dieser Primerschicht weist diese typischerweise eine Schichtdicke > 400nm, beispielsweise von 500 nm bis 1 $\mu$m, auf. Auf diese Primerschicht ist sodann vorzugsweise eine Hartlackschicht aufgebracht, wie vorstehend beschrieben. Die Primerschicht dient einer Verbesserung der Haftung der Hartlackschicht auf dem Kunststoffsubstrat.

Der Primer für die Primerschicht wird vorzugsweise aus der Gruppe, die aus Polyurethandispersion, Polyurethan-Polyharnstoff-Dispersion und Mischungen davon besteht, ausgewählt. Ergänzend wird in dieser Hinsicht auf die US 5,316,791, insbesondere auf Spalte 3, Zeile 41 bis Spalte 6, Zeile 11 Bezug genommen, deren Inhalt hiermit unter Bezugnahme aufgenommen ist. Ein kommerziell erhältlicher Primer ist beispielsweise der Primer PR-1165 der Firma SDC TECHNOLOGIES, INC. 45 Parker, Suite 100 Irvine, CA 92618 USA.

Der Hartlack ist vorzugsweise ein Polysiloxan, das beispielsweise durch Umsetzung wenigstens eines Organosilans und wenigstens eines Tetraalkoxysilans in Gegenwart von kolloidalem anorganischen Oxid, Fluorid oder Oxyfluorid erhältlich ist. Ergänzend wird in dieser Hinsicht auf die DE 10 2011 083 960 A1 Bezug genommen, deren Inhalt hiermit unter Bezugnahme aufgenommen ist. Ein kommerziell erhältlicher Polysiloxan-Hartlack ist beispielsweise der MP-1154D der Firma SDC TECHNOLOGIES, INC. 45 Parker, Suite 100 Irvine, CA 92618 USA

Erfindungsgemäß weist die ausgehärtete Lackschicht bevorzugt eine Rauigkeit < 3 nm rms, vorzugsweise < 2 nm rms, weiter vorzugsweise < 1 nm rms auf.

Die Rauigkeit der Hartlackschicht kann durch die Wahl des Lösemittels, beispielsweise 1 Methoxy-2-propanol, Ethanol und/oder Methanol oder Mischungen davon und/oder durch Verwendung von wenigstens einem Verlaufsadditiv, beispielsweise Silikontensid(e) oder Fluortensid(e), eingestellt werden.

Im Hinblick auf diese bevorzugt geringe Oberflächenrauigkeit sind die nachfolgend aufgebrachte Trennschicht sowie das auf der Trennschicht aufgebrachte erfindungsgemäße Interferenzschichtsystem vorzugsweise als glatte Schichten, die vorzugsweise entsprechend geringe Rauigkeiten aufweisen, ausgebildet. Bei einer glatten Trennschicht sowie einem Interferenzschichtsystem mit glatten Schichten lässt sich das erfindungsgemäße Interferenzschichtsystem leicht von dem Trägersubstrat ablösen. Des Weiteren führen glatte Schichten in dem erfindungsgemäßen Interferenzschichtsystem zu definierten optischen Eigenschaften, beispielsweise definierten Filtereigenschaften.

Bei der vorliegenden Erfindung wird auf das flächige Trägersubstratmaterial eine Trennschicht aufgebracht, die eine Ablösung bzw. Abtrennung der nachfolgend aufgebrachten Mehrzahl von Metalloxid-haltigen Schichten ermöglicht.

Als Trennschicht können verschiedenartige Materialien verwendet werden. Beispielsweise können organische Materialien aufgebracht werden, die in einem organischen Lösemittel lösbar sind. Beispielsweise können als organische Trennmittel Wachse oder Fette, die beispielsweise in organischem Lösemittel löslich sind, verwendet werden.

Erfindungsgemäß ist bevorzugt, als Trennschicht ein wasserlösliches anorganisches Salz zu verwenden. Die Verwendung eines wasserlöslichen Salzes ist im Hinblick auf Arbeitssicherheit und die Umwelt bevorzugt.

Als anorganische Salze werden vorzugsweise Salze der Alkali- und/oder ErdalkaliMetalle verwendet. Als Anionen können die üblichen Salzbildner, beispielsweise Halogenide, Sulfate, Phosphate, etc., verwendet werden. Bevorzugt werden Halogenide, insbesondere Chloride, als Anionen der Salze verwendet. Äußerst bevorzugt wird als kostengünstiges Salz eine Trennschicht aus NaCl verwendet.

Die Trennschicht wird in einer geeigneten Schichtdicke auf das Trägersubstratmaterial aufgebracht. Vorzugsweise wird die Schicht auf das flächige Trägersubstratmaterial mit einer definierten Schichtdicke im Vakuum aufgedampft. Die Trennschichtdicke kann dabei in einem Bereich von 10 nm bis 100 nm, vorzugsweise von 20 nm bis 50 nm liegen. Eine Trennschichtdicke von 30 nm, beispielsweise aus NaCl, hat sich als sehr geeignet erwiesen. Die Trennschicht kann beispielsweise mit einem Elektrodenstrahlverdampfer ohne Reaktivgas aufgebracht werden. Auf diese Trennschicht wird sodann eine definierte Anzahl von Metalloxid-haltigen Schichten nacheinander und vorzugsweise unmittelbar aufeinanderfolgend durch Aufdampfen aufgebracht.

Die Anzahl und Dicke sowie die Beschaffenheit der aufzubringenden Metalloxid-haltigen Schichten wird dabei in Abhängigkeit von dem jeweiligen Verwendungszweck, beispielsweise den optischen Filtereigenschaften des Interferenzschichtsystems, eingestellt. Das Aufbringen der Trennschicht bzw. der Mehrzahl von Metalloxid-haltigen Schichten erfolgt mit einer üblichen Bedampfungsanlage, vorzugsweise einer PVD-Anlage (PVD: Physical Vapour Deposition; deutsch: physikalische Dampfabscheidung). Die weiteren Verfahrensbedingungen, wie beispielsweise Vakuumaufdampfgeschwindigkeit, Inertgas, Reaktivgas, etc., werden gemäß Herstellerangaben und den gewünschten optischen Eigenschaften des erfindungsgemäßen Interferenzschichtsystems eingestellt.

Nach Aufbringung der gewünschten Anzahl von Metalloxid-haltigen Schichten wird die Beschichtungsanlage, üblicherweise eine Vakuumbeschichtungsanlage, belüftet. Die Substrate werden sodann entnommen und in einer wasserdampfhaltigen Atmosphäre gelagert, beispielsweise in der Umgebungsatmosphäre. Vorzugsweise beträgt die relative Luftfeuchtigkeit mehr als 30 %.

Die Trennschicht, beispielsweise die NaCl-Schicht, nimmt aus der Umgebungsatmosphäre Feuchtigkeit auf und verringert so die Haftung zwischen dem aufgedampften Interferenzschichtsystem und dem flächigen Trägersubstratmaterial.

Als Beschichtungsanlage können beispielsweise die Beschichtungsanlagen der Satisloh GmbH, 35578 Wetzlar, beispielsweise die Satisloh 1200-DLX-2 verwendet werden.

Mit der Beschichtungsanlage des Typs Satisloh 1200-DLX-2 können in einem Beschichtungsverlauf mehrere Gramm erfindungsgemäßer Interferenzschichtsysteme unter Verwendung des erfindungsgemäßen Verfahrens hergestellt werden.

Die Berechnung der Anzahl und Dicken der Schichten erfolgt unter Berücksichtigung des jeweiligen Brechungsindex und der gewünschten Filterwirkung computerbasiert. Beispielsweise kann zur Berechnung eines erfindungsgemäßen Interferenzschichtsystems das Softwareprogramm OptiLayer, Version 12.37 der OptiLayer GmbH, 85748 Garching b. München, oder das Softwareprogramm Essential MacLeod Version 11.00.541 der Fa. Thin Film Center Inc., 2745 E Via Rotunda, Tucson, AZ USA, verwendet werden.

Als sehr geeignet hat sich als hochbrechendes transparentes optisches Schichtmaterial Titanoxid, insbesondere $TiO_2$, und als niedrigbrechendes transparentes optisches Schichtmaterial Siliziumoxid, insbesondere $SiO_2$, erwiesen. Das abgelöste Interferenzschichtsystem, vorzugsweise ein Interferenzschichtfilm, oder eine Interferenzschichtfolie, kann in einem geeigneten Medium, beispielsweise in Gas, insbesondere Luft, oder in einer Flüssigkeit, beispielsweise Wasser oder in einer wässrigen Lösung, unter Energieeintrag, beispielsweise durch Rühren oder durch Einstrahlung von Ultraschall, auf eine gewünschte Größe oder Partikelgrößenverteilung zerkleinert werden.

Das erfindungsgemäße Interferenzschichtsystem kann auch direkt in ein Beschichtungsmittel, beispielsweise eine Farbe oder einen Lack, eingebracht und unter Rühren oder Einstrahlen von Ultraschall auf eine gewünschte Partikelgröße bzw. Partikelgrößenverteilung zerkleinert werden.

Die Erfindung wird nachstehend unter Bezug auf Beispiele und Figuren näher veranschaulicht, ohne jedoch darauf beschränkt zu sein.

**Figuren**

Fig. 1 zeigt eine berechnete Reflexionskurve eines erfindungsgemäßen Interferenzschichtsystems aus insgesamt 26 alternierend angeordneten Schichten aus $TiO_2$ und $SiO_2$.

Fig. 2 zeigt den erfindungsgemäßen Interferenzschichtfilm bzw. eine erfindungsgemäße Interferenzschichtfolie, für den die Reflexionskurve aus Fig.1 berechnet und gemessen wurde, auf einem Rasterelektronenmikroskop-Objektträger.

Fig. 3 zeigt eine REM-Aufnahme (REM: Rasterelektronenmikroskop) des erfindungsgemäßen Interferenzschichtfilmes, für den die Reflexionskurve aus Fig.1 berechnet und gemessen wurde und der in Fig.2 zu sehen ist.

Fig. 4 zeigt die Verringerung der Transmission im Wellenlängenbereich zwischen 350 nm und 800 nm bei Verwendung eines Interferenzschichtsystems, für den die Reflexionskurve aus Fig.1 berechnet und gemessen wurde und der in Fig.2 bzw. Fig.3 zu sehen ist.

**Beispiel**

In eine Satisloh 1200- DLF Beschichtungsanlage wurde als flächiges Substratmaterial ein mit einem Polysiloxan-basiertem Hartlack MP-1154D (SDC TECHNOLOGIES, INC.) beschichtetes Kunststoffsubstrat als Trägersubstratmaterial gemäß Herstellerangaben angeordnet.

Das Kunststoffsubstratmaterial war ein unbeschichtetes Brillenglas aus Polymer CR39 der einen kreisförmigen Durchmesser von 6,5 cm und eine Dicke in der Mitte von 1,5 mm aufwies. Auf das Kunststoffsubstratmaterial war zunächst der Primer PR-1156 (SDC TECHNOLOGIES, INC.) in einer Schichtdicke von 750 nm mittels Tauchbeschichtung aufgebracht worden. Die Trocknung erfolgte für 5 min bei einer Temperatur von 70 °C in einem Standofen der Memmert GmbH + Co. KG, D-91126 Schwabach Typ ULE 600. Der Polysiloxan-basierte Hartlack MP-1154D war nachfolgend in einer Schichtdicke von 2500 nm mittels Tauchbeschichtung aufgebracht worden. Die Trocknung und Härtung erfolgte sodann für 120 min bei einer Temperatur von 110 °C in einem Standofen der Fa Memmert GmbH + Co. KG D-91126 Schwabach Typ ULE 600.

Bevor die eigentliche Abscheidung der Schichtmaterialien begann, wurde die Oberfläche im Vakuum bei einem Druck von kleiner $8x10^{-4}$ mbar mit Ionen beaufschlagt. Die Ionen kamen aus einer Ionenquelle des End-Hall-Typs. Diese Ionenquelle ist Bestandteil der Beschichtungsanlage. Die Ionen waren Ar-Ionen mit einer Energie zwischen 80eV und 130 eV. Die auf die Substrate treffende Ionenstromdichte lag zwischen 20 und 60 $\mu A/cm^2$. Die Beaufschlagung mit Ar-Ionen erfolgte für 2 Minuten.

Nach Abschluss der Ar-Ionenbeaufschlagung wurde zunächst im Hochvakuum auf das mit Hartlack versehene Kunststoffsubstratmaterial eine 30 nm dicke Schicht aus NaCl ohne Reaktivgas mit dem Elektronenstrahlverdampfer in der Satisloh Beschichtungsanlage bei einem Druck von $4x10^{-4}$ mbar und mit einer Abscheiderate von 0,2 nm/s aufgebracht. Nachfolgend wurden im Vakuum bei einem Druck von $4x10^{-4}$ mbar insgesamt 26 Schichten aus $TiO_2$ und $SiO_2$ aufgebracht. Während der Beschichtung der $TiO_2$ Schichten wurde Sauerstoff als Reaktivgas zugegeben (20sccm), so dass die Schichten ohne Absorption im sichtbaren Spektralbereich aufwuchsen und somit optisch transparent waren. Während der Abscheidung des $TiO_2$ wurde das Substrat auch mit Ionen beaufschlagt. Diese Ionen kamen aus einer lonenquelle des End-Hall-Typs. Diese lonenquelle ist Bestandteil der Beschichtungsanlage. Die Ionen waren Sauerstoffionen mit einer Energie zwischen 80eV und 130 eV. Die auf die Substrate treffende lonenstromdichte lag zwischen 20 und 60 $\mu$A/cm$^2$. Die Beaufschlagung der aufwachsenden TiO$_2$ Schicht mit Sauerstoffionen trug ebenso wie die Zugabe von Reaktivgas dazu bei, dass die TiO$_2$ Schichten als optisch transparente Schicht aufwuchsen. Dabei wurden Schichten aus TiO$_2$ und Schichten aus SiO$_2$ alternierend aufgebracht. Bei der ersten direkt auf die Trennschicht aus NaCl aufgebrachten Metalloxidschicht handelte es sich um eine TiO$_2$-Schicht. Die jeweils aufgebrachte Schichtdicke der TiO$_2$-Schicht bzw. SiO$_2$-Schicht ist in [nm] in Tabelle 2 angegeben.

**Tabelle 2**

|  |  | t/nm |
|---|---|---|
| Substrat | CR39 |  |
| Primer | PR-1156 | 750 |
| Hartlack | MP-1154D | 2500 |
| Trennschicht | NaCl | 30 |
| 1 | TiO$_2$ | 8.6 |
| 2 | SiO$_2$ | 73.2 |
| 3 | TiO$_2$ | 25.1 |
| 4 | SiO$_2$ | 52.9 |
| 5 | TiO$_2$ | 42.1 |
| 6 | SiO$_2$ | 44.5 |
| 7 | TiO$_2$ | 41.1 |
| 8 | SiO$_2$ | 61.5 |
| 9 | TiO$_2$ | 31.0 |
| 10 | SiO$_2$ | 64.5 |
| 11 | TiO$_2$ | 37.8 |
| 12 | SiO$_2$ | 51.5 |
| 13 | TiO$_2$ | 41.9 |
| 14 | SiO$_2$ | 62.0 |
| 15 | TiO$_2$ | 30.7 |
| 16 | SiO$_2$ | 64.7 |
| 17 | TiO$_2$ | 38.4 |
| 18 | SiO$_2$ | 47.2 |
| 19 | TiO$_2$ | 43.7 |
| 20 | SiO$_2$ | 70.4 |
| 21 | TiO$_2$ | 23.2 |
| 22 | SiO$_2$ | 62.6 |
| 23 | TiO$_2$ | 50.8 |
| 24 | SiO$_2$ | 17.5 |
| 25 | TiO$_2$ | 55.3 |
| 26 | SiO$_2$ | 104.3 |
| t/nm: Dicke in [nm] | | |

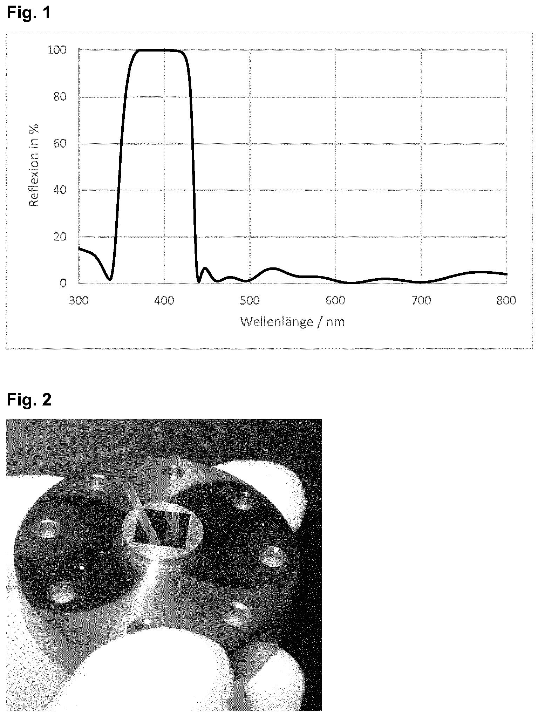

Die Einstellung der jeweiligen Schichtdicke erfolgte über die Dauer der Bedampfung gemäß Herstellerangaben der Beschichtungsanlage. Die Bestimmung der Schichtdicke erfolgte dabei unter Verwendung eines Schwingquarzsystems (XTC Controller, Fa. Inficon, CH-7310 Bad Ragaz), das die Änderung der Frequenz eines elektrischen Schwingquarzes misst, wobei sich die Frequenz mit der Schichtdicke des aufwachsenden Interferenzschichtsystems ändert. Der Schwingquarz wird während des Beschichtungsvorgangs des Kunststoffträgersubstrates in analogerweise mitbeschichtet und dabei dessen Frequenzänderung gemessen. Die berechnete Reflexionskurve des Interferenzschichtsystems mit insgesamt 26 Schichten (siehe Tabelle 2) ist in Fig. 1 gezeigt.

Zur Kontrolle der aufgebrachten Beschichtung wurde eine Messung durchgeführt: Die Messung der Reflexionskurve erfolgte mit dem Reflexionsspektrometer F10-AR-UV der Firma Filmetrics, Inc.(San Diego, CA 92121, USA), indem der Messkopf, nach Kalibrierung des Gerätes gemäß Herstellerangaben, direkt nach Herstellung des Interferenzschichtsystems auf einen beschichteten Bereich des Kunststoffträgersubstrats aufgesetzt wurde. Diese Messung erfolgte innerhalb von 5 min nach Belüften der Vakuumbeschichtungsanlage, nachdem die Beschichtung beendet wurde. Die Messung der Reflexionskurve erfolgte an dem noch auf dem Kunststoffträgersubstrat anhaftenden Interferenzschichtfilm, da die Durchführung der Messung einer Reflexionskurve an einem von dem Kunststoffträgersubstrat abgelösten Interferenzschichtfilm aufwändig ist.

Die Berechnung der jeweils aufgebrachten Schichtdicken erfolgte mit dem Softwareprogramm OptiLayer, Version 12.37, der OptiLayer GmbH. Für die Zwecke der Berechnung der Zielreflexionskurve wurde berücksichtigt, dass das erfindungsgemäße Interferenzschichtsystem auch während der Messung über die Trennschicht, Hartlackschicht und Primerschicht auf dem Trägersubstratmaterial angeordnet vorlag. Für die Berechnung wurde mithin zunächst eine Zielreflexionskurve eingegeben. Das Softwareprogramm verfügte über Algorithmen, die Interferenz-Schichtsysteme unter Berücksichtigung von Randbedingungen berechnen. Für die Berechnung wurde der Algorithmus "gradual evolution" ausgewählt. Als Randbedingung wurden das Substratmaterial, die Primerschicht mit deren optischen Eigenschaften und Schichtdicke, die Hartlackschicht mit deren optischen Eigenschaften und Schichtdicke, die Trennschicht aus NaCl mit deren optischen Eigenschaften und Schichtdicke sowie die Verwendung von $TiO_2$ und $SiO_2$ als Schichtmaterialien vorgegeben. Die maximale Anzahl der Schichten wurde auf 26 begrenzt. Der Algorithmus optimierte die Anzahl der Schichten und deren Dicke, bis eine minimale Abweichung zur Zielkurve erreicht wurde. Als Ergebnis dieser Optimierung erhielt man die in Tabelle 2 angegebenen Schichtdicken. Die Ergebnisse der gemessenen Reflexionskurve stimmten mit der berechneten Zielreflexionskurve überein. Mithin wies auch das von dem Trägersubstrat abgelöste Interferenzschichtsystem die berechnete bzw. gemessene Reflexionskurve auf.

Nach Beendigung des Beschichtungsprozesses wurden die beschichteten Substrate der Beschichtungsanlage entnommen und bei Raumtemperatur im Labor für 5 Stunden stehengelassen. Die relative Luftfeuchtigkeit im Labor betrug mehr als 30 %. Sodann wurde der Interferenzschichtfilm bzw. die Interferenzschichtfolie von der Substratoberfläche mit einer Pinzette abgezogen. Infolge von intrinsischen Spannungen rollte sich der Interferenzschichtfilm bzw. die Interferenzschichtfolie auf, wie in Fig. 2 gezeigt ist.

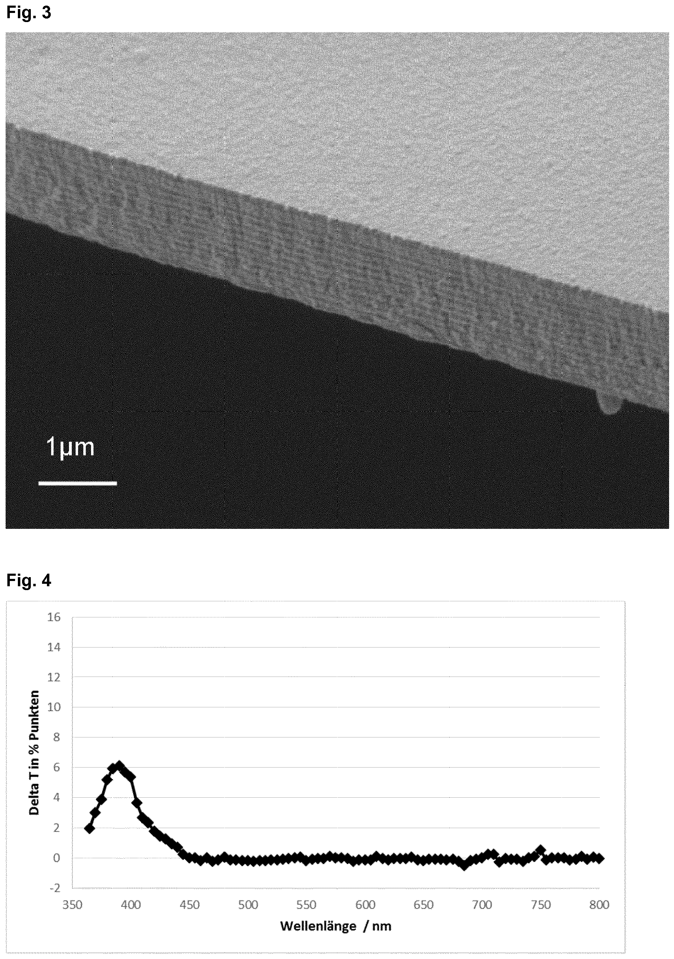

In Fig. 3 ist eine REM-Aufnahme (REM: Rasterelektronenmikroskop) des erfindungsgemäßen Interferenzschichtfilms zu sehen. Die Einzelschichten aus $TiO_2$ und $SiO_2$ sind klar erkennbar. Um die Wirkung in einem höher viskosen Beschichtungsmaterial zu bestimmen, wurden etwa 1 Massen% des abgelösten Interferenzschichtfilms in Glycerin eingerührt. Durch das Rühren wurde der Interferenzschichtfilm unter Erhalt von Interferenzschichtpartikeln zerkleinert. Anschließend wurde ein Film des Interferenzschichtpartikel-haltigen Glycerins auf einen Objektträger in einer Schichtdicke von 50 $\mu$m aufgebracht, und die spektrale Transmission im Wellenlängenbereich von 350 nm bis 1050 nm wurde mit einem einem Ultrascan Spectrophotometer der Firma Hunter Associates Laboratory, Inc. 11491 Sunset Hills Road Reston, VA 20190-5280, USA gemessen. Zur Berechnung des Beitrags der Interferenzschichtpartikel alleine wurde zuvor ein Glycerinfilm ohne Interferenzschichtpartikel vermessen.

In Fig. 4 ist die Transmissionsänderung Delta T durch die Zugabe der Interferenzschichtpartikel aufgetragen. Diese wurde berechnet als Differenz der Transmissionskurve mit und ohne Interferenzschichtpartikel in Glycerin.

Fig. 4 ist zu entnehmen, dass die Zugabe der erfindungsgemäßen Interferenzschichtpartikel zu einer signifikanten Verringerung der Transmission in einem Wellenlängenbereich < 430 nm führte, während die Transmission bei größeren Wellenlängen nicht beeinflusst wurde.

Die mittlere Partikelgröße der erfindungsgemäßen Interferenzschichtpartikel in Glycerin, das als Modell für ein viskoses Beschichtungssystem verwendet wurde, wurde unter einem Lichtmikroskop zu etwa 40 $\mu$m bestimmt.

Bei einer Erhöhung der Interferenzschichtpartikelkonzentration in Glycerin konnte die Transmission weiter verringert werden.

**Patentansprüche**

1. Interferenzschichtsystem, umfassend eine Mehrzahl von optisch transparenten Schichten,
   **dadurch gekennzeichnet,**
   **dass** das Interferenzschichtsystem kein Trägersubstrat aufweist und dass die optisch transparenten Schichten flächig übereinander angeordnet sind, wobei die optisch transparenten Schichten aus der Gruppe, die aus Dielektrika, Metallen und Kombinationen davon besteht, ausgewählt werden, wobei wenigstens eine erste optisch transparente Schicht einen Brechungsindex $n_1$ und wenigstens eine zweite optisch transparente Schicht einen Brechungsindex $n_2$ aufweist und wobei sich der erste Brechungsindex $n_1$ und der zweite Brechungsindex $n_2$ um wenigstens 0,1 unterscheiden.

2. Interferenzschichtsystem nach Anspruch 1,
   **dadurch gekennzeichnet,**
   **dass** die Schichtdicke jeder optisch transparenten Schicht in einem Dickenbereich von 5 nm bis 500 nm liegt.

3. Interferenzschichtsystem nach Anspruch 1 oder 2,
   **dadurch gekennzeichnet,**
   **dass** die optisch transparenten Schichten jeweils Dielektrika, vorzugsweise Metalloxid(e), in einer Menge von 95 bis 100 Gew.-%, jeweils bezogen auf das Gesamtgewicht der jeweiligen optisch transparenten Schicht, aufweisen.

4. Interferenzschichtsystem nach einem der Ansprüche 1 bis 3,
   **dadurch gekennzeichnet,**
   **dass** das Interferenzschichtsystem wenigstens 2 niedrigbrechende optisch transparente Schichten mit einem Brechungsindex $n_1 < 1,8$ und wenigstens 2 hochbrechende optisch transparente Schichten mit einem Brechungsindex $n_2 \geq 1,8$ aufweist.

5. Interferenzschichtsystem nach einem der Ansprüche 1 bis 4,
   **dadurch gekennzeichnet,**
   **dass** das Interferenzschichtsystem 4 bis 100 optisch transparente Schichten aufweist oder daraus besteht.

6. Interferenzschichtsystem nach einem der Ansprüche 1 bis 5,
   **dadurch gekennzeichnet,**
   **dass** die niedrigbrechende optisch transparente Schicht einen Brechungsindex $n_1$ aus einem Bereich von 1,3 bis 1,78 aufweist und vorzugsweise aus der Gruppe, die aus Siliziumoxid, Aluminiumoxid, Magnesiumfluorid, und Mischungen davon besteht, ausgewählt wird.

7. Interferenzschichtsystem nach einem der Ansprüche 1 bis 6,
   **dadurch gekennzeichnet,**
   **dass** die hochbrechende optisch transparente Schicht einen Brechungsindex $n_2$ aus einem Bereich von 2,0 bis 2,9 aufweist und vorzugsweise aus der Gruppe, die aus Titanoxid, Eisenoxid, Nioboxid, Tantaloxid, Zirkoniumoxid, Chromoxid, Ceroxid, Kobaltoxid, und Mischungen davon besteht, ausgewählt wird.

8. Interferenzschichtsystem nach einem der Ansprüche 1 bis 7,
   **dadurch gekennzeichnet,**
   **dass** jede optische transparente Schicht ausschließlich aus einem Metalloxid besteht.

9. Interferenzschichtsystem nach einem der Ansprüche 1 bis 8,
   **dadurch gekennzeichnet,**
   **dass** die niedrigbrechenden und hochbrechenden optischen transparenten Schichten alternierend übereinander und vorzugsweise aneinander angrenzend angeordnet sind.

10. Interferenzschichtsystem nach einem der Ansprüche 1 bis 9,
    **dadurch gekennzeichnet,**
    **dass** das Interferenzschichtsystem eine Folie, ein Film oder ein Partikel ist.

11. Verfahren zur Herstellung eines Interferenzschichtsystems gemäß einem der Ansprüche 1 bis 10,
    **dadurch gekennzeichnet,**
    **dass** das Verfahren folgende Schritte umfasst:

    (a) Bereitstellen eines flächigen Trägersubstratmaterials,
    (b) Aufbringen einer Trennschicht,
    (c) Aufbringen einer Mehrzahl von optisch transparenten Schichten unter Erzeugung eines Interferenzschichtsystems,

(d) Ablösen des Interferenzschichtsystems von dem flächigen Trägersubstratmaterial.

12. Verfahren nach Anspruch 11,
**dadurch gekennzeichnet,**
**dass** die optisch transparenten Schichten aufgedampft werden.

13. Verfahren nach Anspruch 11 oder 12,
**dadurch gekennzeichnet,**
**dass** die Trennschicht aus einem wasserlöslichen anorganischen Salz gebildet wird.

14. Optischer Filter,
**dadurch gekennzeichnet,**
**dass** der optische Filter ein Interferenzschichtsystem nach einem der Ansprüche 1 bis 10 ist oder enthält.

15. Anwendungsmedium,
**dadurch gekennzeichnet,**
**dass** das Anwendungsmedium ein Interferenzschichtsystem nach einem der Ansprüche 1 bis 10 enthält.

**Fig. 1**

**Fig. 2**

**Fig. 3**

1µm

**Fig. 4**

Europäisches
Patentamt

European
Patent Office

Office européen
des brevets

# EUROPÄISCHER RECHERCHENBERICHT

**Nummer der Anmeldung**

EP 19 15 8947

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 270 683 A2 (MERCK PATENT GMBH [DE]) 2. Januar 2003 (2003-01-02) | 1-12,15 | INV. G02B1/115 |
| Y | * Absätze [0009] - [0024], [0037] - [0039], [0045] - [0050], [0053] - [0056] * | 13-15 | B32B43/00 C23C14/00 G02B5/08 G02B5/28 C23C14/24 |
| | ----- | | |
| X | DE 41 24 937 A1 (O I B GMBH OPTISCHE INTERFEREN [DE]) 26. März 1992 (1992-03-26) | 1-14 | |
| Y | * Spalte 1 - Spalte 3; Tabelle 1 * | 13-15 | |
| | ----- | | |
| X | US 2002/171936 A1 (OCKENFUSS GEORG [US] ET AL) 21. November 2002 (2002-11-21) | 1-14 | |
| Y | * Absätze [0002], [0017], [0036] - [0037], [0043], [0046] - [0051] * | 13-15 | |
| | ----- | | |
| X | US 2004/070833 A1 (SARGENT ROBERT B [US] ET AL) 15. April 2004 (2004-04-15) * Absatz [0037] * | 1,5,9-14 | |
| | ----- | | |

**RECHERCHIERTE SACHGEBIETE (IPC)**

G02B
C23C
B32B

Der vorliegende Recherchenbericht wurde für alle Patentansprüche erstellt

| Recherchenort | Abschlußdatum der Recherche | Prüfer |
|---|---|---|
| München | 1. August 2019 | Knorn, Raphaela |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
   Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 19 15 8947

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

01-08-2019

| Im Recherchenbericht angeführtes Patentdokument | Datum der Veröffentlichung | Mitglied(er) der Patentfamilie | Datum der Veröffentlichung |
|---|---|---|---|
| EP 1270683 A2 | 02-01-2003 | DE 10128488 A1<br>EP 1270683 A2<br>JP 2003131029 A<br>US 2003017316 A1 | 19-12-2002<br>02-01-2003<br>08-05-2003<br>23-01-2003 |
| DE 4124937 A1 | 26-03-1992 | KEINE | |
| US 2002171936 A1 | 21-11-2002 | KEINE | |
| US 2004070833 A1 | 15-04-2004 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2437084 A1
- EP 0950693 A1
- US 5316791 A
- DE 102011083960 A1

**In der Beschreibung aufgeführte Nicht-Patentliteratur**

- **E.S. GADELMAWLA et al.** Roughness parameters. *Journal of Materials Processing Technology,* 2002, vol. 123, 133-145
- **OLIVER W.C. ; PHARR, G.M.** Measurement of hardness and elastic modulus by instrumented indentation: Advances in understanding and refinements to methodology. *J. Mater. Res.,* Januar 2004, vol. 19 (1), 3-20